# EUROPÄISCHE PATENTSCHRIFT

(11) **EP 3 236 308 B1**
(45) Veröffentlichungstag und Bekanntmachung des Hinweises auf die Patenterteilung: **15.08.2018**
(21) Anmeldenummer: 16166015.4
(22) Anmeldetag: 19.04.2016
(51) Int. Cl.: G02B 27/09, B23K 26/06, G02B 27/10, G02B 27/28

(54) **LASERVORRICHTUNG**
LASER DEVICE
DISPOSITIF LASER

(43) Veröffentlichungstag der Anmeldung: 25.10.2017
(73) Patentinhaber: LIMO GmbH, 44319 Dortmund (DE)
(72) Erfinder: Mitra, Thomas, 44309 Dortmund (DE); Dommers-Völkel, Sabine, 44143 Dortmund (DE)
(74) Vertreter: Manske, Jörg

(56) Entgegenhaltungen:
- EP-A2- 1 178 346
- CN-A- 102 809 823
- DE-A1- 10 331 695
- JP-A- 2002 250 893
- US-B1- 6 584 060

## Beschreibung

Die vorliegende Erfindung betrifft eine Laservorrichtung, umfassend eine erste Lasereinheit, die während des Betriebs einen Laserstrahl emittieren kann, der sich in einer ersten Richtung ausbreitet, zumindest eine zweite Lasereinheit, die während des Betriebs einen Laserstrahl emittieren kann, der sich in einer zweiten Richtung, die von der ersten Richtung verschieden ist und vorzugsweise orthogonal zu der ersten Richtung orientiert ist, ausbreitet, sowie ein Polarisationskopplungsmittel, das derart angeordnet und so ausgebildet ist, dass es den Laserstrahl der ersten Lasereinheit, der in einer ersten Richtung polarisiert ist, mit dem Laserstrahl der zweiten Lasereinheit, der in einer zweiten Richtung polarisiert ist, derart koppeln kann, dass durch eine kollineare Überlagerung der beiden Laserstrahlen ein erster resultierender Laserstrahl erhalten werden kann. Ein Strahlkombinierer für Hochleistungslaserdioden, welcher die Facetten eines Prismas nutzt, ist aus der Patentveröffentlichung CN-A-102809823 bekannt. Laservorrichtungen der eingangs genannten Art sind aus dem Stand der Technik in unterschiedlichen Ausführungsformen bekannt und weisen zum Beispiel Halbleiterlaserelemente in Form von Laserdiodenbarren oder Stapeln von Laserdiodenbarren, die häufig auch als "Stacks" bezeichnet werden, auf. In Laservorrichtungen der vorgenannten Art kann das von den einzelnen Laserdiodenbarren beziehungsweise Stacks von Laserdiodenbarren emittierte Licht, das unterschiedlich linear polarisiert ist, mit Hilfe eines Polarisationskopplungsmittels zu einem resultierenden Laserstrahl zusammengefasst und anschließend mit entsprechenden Optiken zum Beispiel direkt auf ein zu bearbeitendes Werkstück fokussiert oder in eine Lichtleitfaser eingebracht werden.
Bei der Polarisationskopplung werden zumindest zwei unterschiedlich linear polarisierte, insbesondere senkrecht zueinander polarisierte, Laserstrahlen, die sich in zwei unterschiedlichen, insbesondere zueinander orthogonalen, Raumrichtungen ausbreiten, mit Hilfe eines Polarisationskopplungsmittels gekoppelt und dadurch kollinear zu einem resultierenden Laserstrahl überlagert. Derartige Polarisationskopplungsmittel sind häufig als Spiegel mit einer dielektrischen Beschichtung ausgebildet, die zum Beispiel für eine zur Einfallsebene senkrechte Polarisationsrichtung idealerweise einen Reflexionsgrad Rₛ = 100% und für eine zur Einfallsebene parallele Polarisationsrichtung idealerweise einen Reflexionsgrad Rₚ = 0% aufweist.

Die vorliegende Erfindung macht es sich zur Aufgabe, eine Laservorrichtung der eingangs genannten Art zur Verfügung zu stellen, die auf einem alternativen Wege eine Polarisationskopplung von zumindest zwei unterschiedlich linear polarisierten Laserstrahlen ermöglicht.

Die Lösung dieser Aufgabe liefert eine Laservorrichtung der eingangs genannten Art mit den Merkmalen des kennzeichnenden Teils des Anspruchs 1. Die Unteransprüche betreffen vorteilhafte Weiterbildungen der Erfindung.

Eine erfindungsgemäße Laservorrichtung zeichnet sich dadurch aus, dass das Polarisationskopplungsmittel als Polarisationskopplungsprisma ausgebildet ist, das eine Lichteintrittsfläche, durch die der Laserstrahl der ersten Lasereinheit in das Polarisationskopplungsprisma eintreten kann, eine Reflexionsfläche, die relativ zur Lichteintrittsfläche so angeordnet ist, dass der Laserstrahl der ersten Lasereinheit unter einem Winkel auf die Reflexionsfläche auftrifft, der größer als ein Grenzwinkel der inneren Totalreflexion ist, und eine Lichtaustrittsfläche, durch die der Laserstrahl der ersten Lasereinheit nach der inneren Totalreflexion an der Reflexionsfläche aus dem Polarisationskopplungsprisma austreten und an dieser gebrochen werden kann, umfasst und wobei die zweite Lasereinheit relativ zum Polarisationskopplungsprisma so angeordnet ist, dass der Laserstrahl der zweiten Lasereinheit derart auf die Lichtaustrittsfläche auftreffen kann, dass er an dieser in eine Richtung reflektiert werden kann, die der Ausbreitungsrichtung des an der Lichtaustrittsfläche gebrochenen Laserstrahls der ersten Lasereinheit entspricht, so dass durch die kollineare Überlagerung der beiden Laserstrahlen der erste resultierende Laserstrahl erhalten werden kann. Die erfindungsgemäße Laservorrichtung ermöglicht auf eine alternative Weise eine Polarisationskopplung der mindestens zwei unterschiedlich linear polarisierten Laserstrahlen, mittels derer ein erster resultierender Laserstrahl unter Beibehaltung der Strahlqualität erhalten werden kann, dessen Leistung im Wesentlichen der Summe der Leistungen des polarisierten Laserstrahls der ersten Lasereinheit und des polarisierten Laserstrahls der zweiten Lasereinheit entspricht.

Um mögliche Reflexionsverluste beim Auftreffen des Laserstrahls der ersten Lasereinheit auf die Lichteintrittsfläche zu vermeiden beziehungsweise zumindest zu verringern, wird in einer vorteilhaften Ausführungsform vorgeschlagen, dass die Lichteintrittsfläche des Polarisationskopplungsprismas eine Antireflexionsbeschichtung aufweist. Vorzugsweise kann es sich dabei um eine dielektrische Antireflexionsbeschichtung handeln.

In einer besonders vorteilhaften Ausführungsform kann vorgesehen sein, dass die Lichtaustrittsfläche des Polarisationskopplungsprismas eine dielektrische Beschichtung aufweist, die für den in der ersten Richtung polarisierten Laserstrahl der ersten Lasereinheit einen Reflexionsgrad R_{P} = 0% und einen Transmissionsgrad T_{P} = 100% hat. Durch diese Maßnahme können Reflexionsverluste beim Auftreffen des an der Reflexionsfläche totalreflektierten Laserstrahls der ersten Lasereinheit auf die Lichtaustrittsfläche in vorteilhafter Weise vermieden werden.

In einer vorteilhaften Ausführungsform besteht die Möglichkeit, dass die dielektrische Beschichtung für den in der zweiten Richtung polarisierten Laserstrahl der zweiten Lasereinheit einen Reflexionsgrad R_{S} = 100% und einen Transmissionsgrad T_{S} = 0% hat. Dadurch können Transmissionsverluste beim Auftreffen des Laserstrahls der zweiten Lasereinheit auf die Lichtaustrittsfläche in vorteilhafter Weise ebenfalls vermieden werden.

Vorzugsweise kann das Polarisationskopplungsprisma relativ zur ersten Lasereinheit derart angeordnet sein, dass der Laserstrahl der ersten Lasereinheit parallel zu einer Oberflächennormalen gerichtet auf die Lichteintrittsfläche auftrifft. Durch diese senkrechte Inzidenz des polarisierten Laserstrahls der ersten Lasereinheit auf die Lichteintrittsfläche wird ein hoher Transmissionsgrad für den Strahlengang dieses polarisierten Laserstrahls der ersten Lasereinheit erreicht.

In einer bevorzugten Ausführungsform wird vorgeschlagen, dass der Laserstrahl der ersten Lasereinheit in einer Richtung parallel zu einer Einfallsebene, in der dieser Laserstrahl auf das Polarisationskopplungsprisma trifft, polarisiert ist. Vorzugsweise kann der Laserstrahl der zweiten Lasereinheit in einer Richtung senkrecht zu einer Einfallsebene, in der dieser Laserstrahl auf das Polarisationskopplungsprisma trifft, polarisiert sein. Insbesondere können die beiden Laserstrahlen also orthogonal zueinander polarisiert sein.

Es besteht in einer vorteilhaften Ausführungsform die Möglichkeit, dass der Laserstrahl der ersten Lasereinheit eine zentrale Wellenlänge λ1 aufweist, die mit einer zentralen Wellenlänge λ1 des Laserstrahls der zweiten Lasereinheit identisch ist.

In einer besonders vorteilhaften Weiterbildung wird vorgeschlagen, dass die Laservorrichtung zumindest eine dritte Lasereinheit, die während des Betriebs einen Laserstrahl emittieren kann, und ein Wellenlängenkopplungsmittel umfasst, das im Strahlengang der Laservorrichtung derart angeordnet ist, dass es den polarisationsgekoppelten ersten resultierenden Laserstrahl kollinear mit dem Laserstrahl der dritten Lasereinheit überlagern kann, so dass ein zweiter resultierender Laserstrahl erhalten werden kann. Durch diese Wellenlängenkopplung kann die Leistung der Laservorrichtung weiter erhöht werden.

Vorzugsweise kann das Wellenlängenkopplungsmittel als Spiegel ausgebildet sein, der eine mehrlagige dielektrische Beschichtung aufweist. Dadurch kann eine effiziente Wellenlängenkopplung erreicht werden.

In einer bevorzugten Ausführungsform wird vorgeschlagen, dass das Wellenlängenkopplungsmittel, insbesondere der Spiegel, derart im Strahlengang der Laservorrichtung angeordnet ist, dass der erste resultierende Laserstrahl und der Laserstrahl der dritten Lasereinheit beim Auftreffen auf das Wellenlängenkopplungsmittel einen Winkel > 90° miteinander einschließen.

In einer vorteilhaften Ausführungsform wird vorgeschlagen, dass der Laserstrahl der dritten Lasereinheit eine zentrale Wellenlänge λ2 aufweist, die von den zentralen Wellenlängen λ1 der Laserstrahlen der ersten Lasereinheit und der zweiten Lasereinheit verschieden ist.

In einer bevorzugten Ausführungsform kann vorgesehen sein, dass die dielektrische Beschichtung des Spiegels so ausgebildet ist, dass sie für den Einfallswinkel, unter dem der von der dritten Lasereinheit emittierte Laserstrahl auf den Spiegel auftrifft, einen Transmissionsgrad T_{λ2} = 100% und einen Reflexionsgrad R_{λ2} = 0% für den Laserstrahl aufweist. Durch diese Maßnahme kann eine maximale Transmission des von der dritten Lasereinheit emittierten Laserstrahls erreicht werden.

In einer besonders bevorzugten Ausführungsform besteht die Möglichkeit, dass die dielektrische Beschichtung des Spiegels so ausgebildet ist, dass sie für den Einfallswinkel, unter dem der polarisationsgekoppelte erste resultierende Laserstrahl auf den Spiegel auftrifft, einen Reflexionsgrad R_{λ1} = 100% und einen Transmissionsgrad T_{λ1} = 0% aufweist. Dadurch können Transmissionsverluste in vorteilhafter Weise verhindert werden.

Die hier vorgestellte Laservorrichtung, bei der der polarisationsgekoppelte erste resultierende Laserstrahl mit der zentralen Wellenlänge λ1 und der Laserstrahl der dritten Lasereinheit mit der zentralen Wellenlänge λ2 beim Auftreffen auf das Wellenlängenkopplungsmittel vorzugsweise einen Winkel > 90° miteinander einschließen, ermöglicht insbesondere einen einfacheren Aufbau des vorzugsweise als Spiegel ausgebildeten Wellenlängenkopplungsmittels, dessen dielektrische Beschichtung deutlich weniger Lagen aufweisen kann als dieses bei herkömmlichen Wellenlängenkopplungsmitteln der Fall ist. Die Kosten für die Herstellung des Wellenlängenkopplungsmittels können dadurch reduziert werden. Ferner können Absorptionseffekte in vorteilhafter Weise verringert werden. Wenn die Anzahl der Lagen der dielektrischen Beschichtung des Spiegels im Vergleich zu den herkömmlichen, als Wellenlängenkopplungsmittel verwendeten Spiegeln nicht reduziert wird, kann der durch die Polarisationskopplung erhaltene erste resultierende Laserstrahl mit dem Laserstrahl der dritten Lasereinheit gekoppelt werden, wobei der Wellenlängenunterschied Δλ = λ2 - λ1 kleiner als im Stand der Technik sein kann. Somit ist in vorteilhafter Weise die Kopplung engerer Wellenlängen λ1, λ2 möglich.

Gemäß einem weiteren Aspekt betrifft die vorliegende Erfindung eine Laservorrichtung, umfassend eine erste Lasereinheit, die während des Betriebs einen in einer ersten Polarisationsrichtung polarisierten Laserstrahl mit einer zentralen Wellenlänge emittieren kann, der sich in einer ersten Richtung ausbreitet, zumindest eine zweite Lasereinheit, die während des Betriebs einen in der ersten Polarisationsrichtung polarisierten Laserstrahl emittieren kann, der eine zentrale Wellenlänge aufweist, die von der zentralen Wellenlänge des Laserstrahls der ersten Lasereinheit verschieden ist und der sich in einer zweiten Richtung, die von der ersten Richtung verschieden ist und vorzugsweise orthogonal zu der ersten Richtung orientiert ist, ausbreitet, sowie ein Wellenlängenkopplungsmittel, das derart angeordnet und so ausgebildet ist, dass es den Laserstrahl der ersten Lasereinheit mit dem Laserstrahl der zweiten Lasereinheit, derart koppeln kann, dass durch eine kollineare Überlagerung der beiden Laserstrahlen ein erster resultierender Laserstrahl erhalten werden kann.

Zur Wellenlängenkopplung von Laserstrahlen werden im Stand der Technik in der Regel Wellenlängenkopplungsmittel eingesetzt, die als Spiegel mit einer dielektrischen Beschichtung ausgeführt sind.

Die Erfindung macht es sich weiterhin zur Aufgabe, eine gattungsgemäße Laservorrichtung zu schaffen, die eine Wellenlängenkopplung zweier Laserstrahlen auf eine alternative Art und Weise ermöglicht.

Gemäß Anspruch 14 zeichnet sich eine weitere erfindungsgemäße Laservorrichtung dadurch aus, dass das Wellenlängenkopplungsmittel als Wellenlängenkopplungsprisma ausgebildet ist, das eine Lichteintrittsfläche, durch die der Laserstrahl der ersten Lasereinheit in das Wellenlängenkopplungsprisma eintreten kann, eine Reflexionsfläche, die relativ zur Lichteintrittsfläche so angeordnet ist, dass der Laserstrahl der ersten Lasereinheit unter einem Winkel auf die Reflexionsfläche auftrifft, der größer als ein Grenzwinkel der inneren Totalreflexion ist, und eine Lichtaustrittsfläche, durch die der Laserstrahl der ersten Lasereinheit nach der inneren Totalreflexion an der Reflexionsfläche aus dem Wellenlängenkopplungsprisma austreten und an dieser gebrochen werden kann, umfasst und wobei die zweite Lasereinheit relativ zum Wellenlängenkopplungsprisma so angeordnet ist, dass der Laserstrahl der zweiten Lasereinheit derart auf die Lichtaustrittsfläche auftreffen kann, dass er an dieser in eine Richtung reflektiert werden kann, die der Ausbreitungsrichtung des an der Lichtaustrittsfläche gebrochenen Laserstrahls der ersten Lasereinheit entspricht, so dass durch die kollineare Überlagerung der beiden Laserstrahlen der erste resultierende Laserstrahl erhalten werden kann.

Die erfindungsgemäße Laservorrichtung ermöglicht auf eine alternative Weise eine Wellenlängenkopplung der mindestens zwei identisch polarisierten Laserstrahlen, mittels derer ein erster resultierender Laserstrahl unter Beibehaltung der Strahlqualität erhalten werden kann, dessen Leistung im Wesentlichen der Summe der Leistungen des Laserstrahls der ersten Lasereinheit und des Laserstrahls der zweiten Lasereinheit entspricht. Die gemeinsame Idee der unabhängigen Ansprüche 1 und 14 besteht somit darin, ein Prisma zu verwenden, das gemäß Anspruch 1 der Polarisationskopplung zweier Laserstrahlen und gemäß Anspruch 14 der Wellenlängenkopplung zweier Laserstrahlen dient.

In einer vorteilhaften Weiterbildung wird vorgeschlagen, dass die Laservorrichtung zumindest eine dritte Lasereinheit, die während des Betriebs einen Laserstrahl emittieren kann, der in einer zweiten Polarisationsrichtung polarisiert ist, die von der ersten Polarisationsrichtung verschieden ist, und ein Polarisationskopplungsmittel umfasst, das im Strahlengang der Laservorrichtung derart angeordnet ist, dass es den ersten resultierenden Laserstrahl kollinear mit dem Laserstrahl der dritten Lasereinheit überlagern kann, so dass ein zweiter resultierender Laserstrahl erhalten werden kann, wobei das Polarisationskopplungsmittel vorzugsweise als Spiegel ausgebildet ist, der eine mehrlagige dielektrische Beschichtung aufweist. Im Gegensatz zur Ausführungsvariante gemäß Anspruch 9 wird der Spiegel mit der dielektrischen Beschichtung vorliegend zur Polarisationskopplung verwendet. Vorzugsweise sind die beiden Polarisationsrichtungen orthogonal zueinander orientiert. Durch die Polarisationskopplung kann die Leistung der Laservorrichtung weiter erhöht werden.Um mögliche Reflexionsverluste beim Auftreffen des Laserstrahls der ersten Lasereinheit auf die Lichteintrittsfläche des Wellenlängenkopplungsprismas zu vermeiden beziehungsweise zumindest zu verringern, wird in einer vorteilhaften Ausführungsform vorgeschlagen, dass die Lichteintrittsfläche eine Antireflexionsbeschichtung aufweist. Vorzugsweise kann es sich dabei um eine dielektrische Antireflexionsbeschichtung handeln.

In einer besonders vorteilhaften Ausführungsform kann vorgesehen sein, dass die Lichtaustrittsfläche des Wellenlängenkopplungsprismas eine dielektrische Beschichtung aufweist, die für den Laserstrahl der ersten Lasereinheit einen Reflexionsgrad R_{λ1} = 0% und einen Transmissionsgrad T_{λ1} = 100% hat. Durch diese Maßnahme können Reflexionsverluste beim Auftreffen des an der Reflexionsfläche totalreflektierten Laserstrahls der ersten Lasereinheit auf die Lichtaustrittsfläche in vorteilhafter Weise vermieden werden.

In einer vorteilhaften Ausführungsform besteht die Möglichkeit, dass die dielektrische Beschichtung der Lichtaustrittsfläche für den Laserstrahl der zweiten Lasereinheit einen Reflexionsgrad R_{λ2} = 100% und einen Transmissionsgrad T_{λ2} = 0% hat. Dadurch können Transmissionsverluste beim Auftreffen des Laserstrahls der zweiten Lasereinheit auf die Lichtaustrittsfläche in vorteilhafter Weise ebenfalls vermieden werden.

Vorzugsweise kann das Wellenlängenkopplungsprisma relativ zur ersten Lasereinheit derart angeordnet sein, dass der Laserstrahl der ersten Lasereinheit parallel zu einer Oberflächennormalen gerichtet auf die Lichteintrittsfläche auftrifft. Durch diese senkrechte Inzidenz des Laserstrahls der ersten Lasereinheit auf die Lichteintrittsfläche wird ein hoher Transmissionsgrad für den Strahlengang des Laserstrahls der ersten Lasereinheit erreicht.

In einer bevorzugten Ausführungsform wird vorgeschlagen, dass das Polarisationskopplungsmittel, insbesondere der Spiegel, derart im Strahlengang der Laservorrichtung angeordnet ist, dass der erste resultierende Laserstrahl und der Laserstrahl der dritten Lasereinheit beim Auftreffen auf das Polarisationskopplungsmittel einen Winkel > 90° miteinander einschließen.

In einer bevorzugten Ausführungsform kann vorgesehen sein, dass die dielektrische Beschichtung des Spiegels so ausgebildet ist, dass sie für den Einfallswinkel, unter dem der von der dritten Lasereinheit emittierte (polarisierte) Laserstrahl auf den Spiegel auftrifft, einen Transmissionsgrad T = 100% und einen Reflexionsgrad R = 0% für den Laserstrahl aufweist. Durch diese Maßnahme kann eine maximale Transmission des von der dritten Lasereinheit emittierten Laserstrahls erreicht werden.

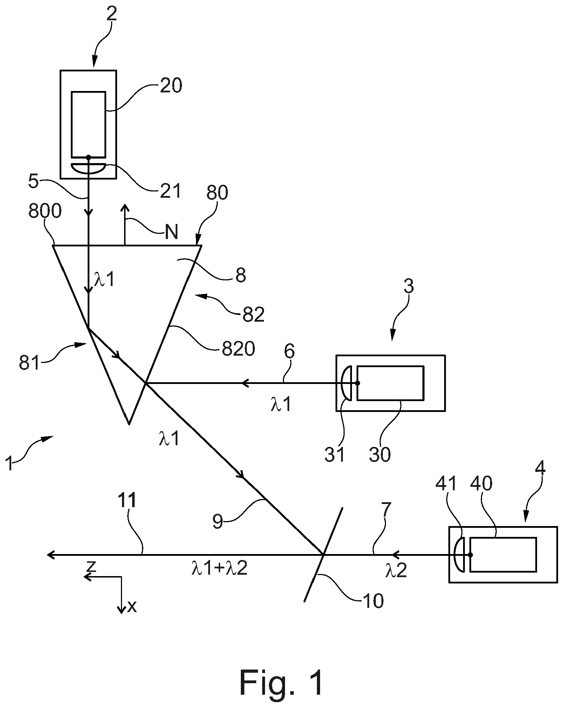

In einer besonders bevorzugten Ausführungsform besteht die Möglichkeit, dass die dielektrische Beschichtung des Spiegels so ausgebildet ist, dass sie für den Einfallswinkel, unter dem der polarisierte, wellenlängengekoppelte erste resultierende Laserstrahl auf den Spiegel auftrifft, einen Reflexionsgrad R = 100% und einen Transmissionsgrad T = 0% aufweist. Dadurch können Transmissionsverluste in vorteilhafter Weise verhindert werden. Weitere Merkmale und Vorteile der vorliegenden Erfindung werden deutlich anhand der nachfolgenden Beschreibung eines bevorzugten Ausführungsbeispiels unter Bezugnahme auf die beiliegende Fig. 1, die einen optischen Strahlengang einer Laservorrichtung 1 zeigt. Ferner wurde in Fig. 1 zusätzlich ein kartesisches Koordinatensystem eingezeichnet, das eine erste Raumrichtung (x-Richtung) und eine zweite Raumrichtung (z-Richtung), die sich orthogonal zur ersten Raumrichtung erstreckt, symbolisiert.

Die Laservorrichtung 1 umfasst in diesem Ausführungsbeispiel insgesamt drei Lasereinheiten 2, 3, 4, die jeweils ein Halbleiterlaserelement 20, 30, 40 sowie diesem zugeordnete Optikmittel 21, 31, 41 umfassen. Die Halbleiterlaserelemente 20, 30, 40 können vorzugsweise als Laserdiodenbarren oder als Stapel von Laserdiodenbarren (so genannte "Stacks") ausgebildet sein. Die Optikmittel 21, 31, 41, die in Ausbreitungsrichtung der von den Halbleiterlaserelementen 20, 30, 40 emittierten Laserstrahlen 5, 6, 7 hinter den Halbleiterlaserelementen 20, 30, 40 angeordnet sind, sind in Fig. 1 lediglich schematisch vereinfacht als Linsen dargestellt. Die Optikmittel 21, 31, 41 können insbesondere eine Fast-Axis-Kollimationslinse, ein oder mehrere Slow-Axis-Kollimationslinsen sowie weitere Strahlformungsmittel umfassen. Die Fast-Axis-Kollimationslinsen dienen dabei einer zumindest teilweisen Kollimierung der von den Halbleiterlaserelementen 20, 30, 40 emittierten Laserstrahlen 5, 6, 7 in der so genannten Fast-Axis-Richtung, in der sie eine größere Strahldivergenz aufweisen als in einer sich senkrecht zur Fast-Axis-Richtung erstreckenden Richtung, die auch als Slow-Axis-Richtung bezeichnet wird. Dementsprechend dienen die Slow-Axis-Kollimationslinsen einer zumindest teilweisen Kollimierung der von den Halbleiterlaserelementen 20, 30, 40 emittierten Laserstrahlen 5, 6, 7 in der Slow-Axis-Richtung. Die weiteren Strahlformungsmittel der Optikmittel 21, 31, 41 der Lasereinheiten 2, 3, 4 können beispielsweise Homogenisierer oder auch Linsenkombinationen zur Zusammenfassung einzelner Teilstrahlen der resultierenden, von den Halbleiterlaserelementen 20, 30, 40 emittierten Laserstrahlen 5, 6, 7 sein. Eine jede der Lasereinheiten 2, 3, 4 kann somit derart gestaltet sein, dass ein relativ gut kollimierter, insbesondere homogener und gut fokussierbarer Laserstrahl 5, 6, 7 aus ihnen austritt.

Die in Fig. 1 abgebildete Laservorrichtung 1 umfasst weiterhin ein Polarisationskopplungsmittel, das als Polarisationskopplungsprisma 8 ausgebildet ist. Dieses Polarisationskopplungsprisma 8 ist im Strahlengang der Laservorrichtung 1 derart angeordnet und so ausgebildet, dass es den Laserstrahl 5 einer ersten Lasereinheit 2 der Laservorrichtung 1, der in einer Richtung parallel zu einer Einfallsebene, in der der Laserstrahl 5 auf das Polarisationskopplungsprisma 8 trifft, polarisiert ist, mit einem Laserstrahl 6 einer zweiten Lasereinheit 3, der in einer Richtung senkrecht zu der Einfallsebene polarisiert ist, derart koppeln kann, dass durch eine kollineare Überlagerung dieser beiden Laserstrahlen 5, 6 ein erster resultierender Laserstrahl 9 unter Beibehaltung der Strahlqualität erhalten werden kann. Der Laserstrahl 5 der ersten Lasereinheit 2 und der Laserstrahl 6 der zweiten Lasereinheit 3 weisen dabei dieselbe zentrale Wellenlänge λ1 auf.

Das Polarisationskopplungsprisma 8 ist vorliegend ein gerades Prisma, das eine Grundfläche in Form eines gleichschenkligen Dreiecks aufweist. Das Polarisationskopplungsprisma 8 weist eine Lichteintrittsfläche 80 auf, durch die der parallel zur Einfallsebene polarisierte (p-polarisierte) Laserstrahl 5 der ersten Lasereinheit 2 in das Polarisationskopplungsprisma 8 in x-Richtung parallel zu einer Oberflächennormalen N gerichtet eintreten kann. Das Polarisationskopplungsprisma 8 weist ferner eine Reflexionsfläche 81 auf, die mit der Lichteintrittsfläche 80 einen Winkel einschließt, der so gewählt ist, dass der sich in x-Richtung ausbreitende p-polarisierte Laserstrahl 5 der ersten Lasereinheit 2 auf die Reflexionsfläche 81 unter einem Winkel auftrifft, der größer ist als der Grenzwinkel der inneren Totalreflexion. Dadurch erfährt der p-polarisierte Laserstrahl 5 der ersten Lasereinheit 2 an der Reflexionsfläche 81 eine innere Totalreflexion ohne Reflexionsverluste. Durch die senkrechte Inzidenz des p-polarisierten Laserstrahls 5 der ersten Lasereinheit 2 auf die Lichteintrittsfläche 80 wird ein hoher Transmissionsgrad für den Strahlengang des p-polarisierten Laserstrahls 5 der ersten Lasereinheit 2 erreicht. Um darüber hinaus mögliche Reflexionsverluste an der Lichteintrittsfläche 80 zu vermeiden beziehungsweise zumindest zu verringern, ist es in diesem Zusammenhang vorteilhaft, dass die Lichteintrittsfläche 80 - wie in diesem Ausführungsbeispiel vorgesehen - eine Antireflexionsbeschichtung 800 aufweist.

Das Polarisationskopplungsprisma 8 umfasst ferner eine Lichtaustrittsfläche 82, die eine dielektrische Beschichtung 820 umfasst, die für parallel zur Einfallsebene polarisiertes Licht einen Reflexionsgrad Rp = 0% und einen Transmissionsgrad Tp = 100% und für senkrecht zur Einfallsebene polarisiertes Licht einen Reflexionsgrad Rs = 100% und einen Transmissionsgrad Ts = 0% hat. Durch diese Maßnahme wird erreicht, dass der an der Reflexionsfläche 81 des Polarisationskopplungsprismas 8 totalreflektierte, p-polarisierte Laserstrahl 5 der ersten Lasereinheit 2 an der Lichtaustrittsfläche 82 nicht reflektiert wird, sondern eine maximale Transmission erfährt und dabei gebrochen wird.

Die zweite Lasereinheit 3 ist so angeordnet, dass sich der von ihr emittierte s-polarisierte Laserstrahl 6 in x-Richtung ausbreitet und an einer Position auf die Lichtaustrittsfläche 82 auftrifft und an dieser aufgrund des Reflexionsgrades R_{S} = 100% eine Totalreflexion erfährt, an der der p-polarisierte Laserstrahl 5 der ersten Lasereinheit 2 seinerseits aus der Lichtaustrittsfläche 82 austritt und dabei gebrochen wird. Der Reflexionswinkel des s-polarisierten Laserstrahls 6 an der Lichtaustrittsfläche 82 entspricht dabei dem Brechungswinkel des p-polarisierten Laserstrahls 5 an der Lichtaustrittsfläche 82. Auf diese Weise können der p-polarisierte Laserstrahl 5 der ersten Lasereinheit 2 und der s-polarisierte Laserstrahl 6 der zweiten Lasereinheit 3 kollinear zu einem ersten resultierenden Laserstrahl 9 mit der zentralen Wellenlänge λ1 überlagert werden. Durch diese Polarisationskopplung werden der p-polarisierte Laserstrahl 5 der ersten Lasereinheit 2 und der s-polarisierte Laserstrahl 6 der zweiten Lasereinheit 3 ohne Änderung der Strahlparameter zu dem ersten resultierenden Laserstrahl 9 zusammengeführt, dessen Leistung der Summe der Leistungen des p-polarisierten Laserstrahls 5 und des s-polarisierten Laserstrahls 6 entspricht.

Der Laserstrahl 7, der von der dritten Lasereinheit 4 emittiert wird, hat eine zentrale Wellenlänge λ2, die von den (identischen) zentralen Wellenlängen λ1 des p-polarisierten Laserstrahls 5 der ersten Lasereinheit 2 und des s-polarisierten Laserstrahls 6 der zweiten Lasereinheit 3 verschieden ist. Wie in Fig. 1 zu erkennen, breitet sich der von der dritten Lasereinheit 4 emittierte Laserstrahl 7 in z-Richtung parallel zu dem s-polarisierten Laserstrahl 6 der zweiten Lasereinheit 3 vor dessen Reflexion an der Lichtaustrittsfläche 82 des Polarisationskopplungsprismas 8 aus.

Die Laservorrichtung 1 weist ferner ein Wellenlängenkopplungsmittel auf, welches dazu eingerichtet ist, den durch Polarisationskopplung erhaltenen ersten resultierenden Laserstrahl 9 mit dem von der dritten Lasereinheit 4 emittierten Laserstrahl 7 zu koppeln und kollinear zu einem zweiten resultierenden Laserstrahl 11 zu vereinigen, der sich vorliegend in z-Richtung ausbreitet. Das Wellenlängenkopplungsmittel, mit Hilfe dessen die Leistung der Laservorrichtung 1 weiter erhöht werden kann, ist vorliegend als Spiegel 10 ausgebildet, der eine mehrlagige dielektrische Beschichtung aufweist. Wie in Fig. 1 zu erkennen, ist der Spiegel 10 in Bezug auf die z-Richtung, die sowohl die Ausbreitungsrichtung des von der dritten Lasereinheit 4 emittierten Laserstrahls 7, als auch die Ausbreitungsrichtung des zweiten resultierenden Laserstrahls 11 bildet, geneigt ausgerichtet. Die mehrlagige dielektrische Beschichtung des Spiegels 10 ist so ausgebildet, dass sie für den Einfallswinkel des von der dritten Lasereinheit 4 emittierten Laserstrahls 7 einen Transmissionsgrad T_{λ2} = 100 % und einen Reflexionsgrad P_{λ2} = 0 % aufweist. Der Einfallswinkel des ersten resultierenden Laserstrahls 9 auf den Spiegel 10 ist so gewählt, dass der erste resultierende Laserstrahl 9 von dem Spiegel 10 in Richtung der Ausbreitungsrichtung des von der dritten Lasereinheit 4 emittierten Laserstrahls 7, die vorliegend die z-Richtung ist, reflektiert werden kann. Dadurch werden der von der dritten Lasereinheit 4 emittierte Laserstrahl 7 sowie der an dem Wellenlängenkopplungsmittel 10 reflektierte erste resultierende Laserstrahl 9 kollinear zu dem zweiten resultierenden Laserstrahl 11 überlagert, der sich in z-Richtung ausbreitet. Die mehrlagige dielektrische Beschichtung des Spiegels 10 ist so ausgebildet, dass diese für den Einfallswinkel, unter dem der erste resultierende Laserstrahl 9 auf den Spiegel 10 auftrifft, einen Reflexionsgrad R_{λ1} = 100% und einen Transmissionsgrad T_{λ1} = 0% aufweist.

Der optische Strahlengang der Laservorrichtung 1 ermöglicht eine effiziente Polarisations- und Wellenlängenkopplung der von drei Lasereinheiten 2, 3, 4 emittierten Laserstrahlen 5, 6, 7, ohne dass für die Polarisationskopplung 90°- Strahlumlenkungen, wie sie bei herkömmlichen Polarisationskopplungsmitteln auftreten, erforderlich sind. Gleichzeitig wird das Konzept aufrechterhalten, dass sich der p-polarisierte Laserstrahl 5 der ersten Lasereinheit 2 und der s-polarisierte Laserstrahl 6 der zweiten Lasereinheit 3 vor dem Auftreffen auf das Polarisationskopplungsprisma 8 orthogonal zueinander ausbreiten. Dadurch kann die Justage der ersten Lasereinheit 2 und der zweiten Lasereinheit 3 im Strahlengang der Laservorrichtung 1 vereinfacht werden. Ebenso vorteilhaft ist es, dass sich das Laserlicht 7 der dritten Lasereinheit 4 parallel zum Laserstrahl 6 der zweiten Lasereinheit 3 vor dessen Auftreffen auf das Polarisationskopplungsprisma 8 ausbreitet.

Die hier vorgestellte Laservorrichtung 1 ermöglicht insbesondere einen einfacheren Aufbau des als Spiegel 10 ausgebildeten Wellenlängenkopplungsmittels, dessen dielektrische Beschichtung deutlich weniger Lagen aufweisen kann als dieses bei herkömmlichen Wellenlängenkopplungsmitteln der Fall ist. Die Kosten für die Herstellung des Spiegels 10 können dadurch reduziert werden. Ferner können Absorptionseffekte in vorteilhafter Weise verringert werden.

Wenn die Anzahl der Lagen der dielektrischen Beschichtung des Spiegels 10 im Vergleich zu den herkömmlichen, als Wellenlängenkopplungsmittel verwendeten Spiegeln nicht reduziert wird, kann der durch die Polarisationskopplung erhaltene erste resultierende Laserstrahl 9 mit dem Laserstrahl 7 der dritten Lasereinheit 4 gekoppelt werden, wobei dabei der Wellenlängenunterschied Δλ = λ2 - λ1 kleiner als im Stand der Technik sein kann. Somit ist in vorteilhafter Weise die Kopplung engerer Wellenlängen λ1, λ2 möglich.

Das in Fig. 1 gezeigte Konzept ermöglicht grundsätzlich auch eine Wellenlängenkopplung mit Hilfe des Polarisationskopplungsprismas 8, welches dann als Wellenlängenkopplungsprisma fungiert. Dann weist der von der ersten Lasereinheit 2 emittierte Laserstrahl 5 eine zentrale Wellenlänge λ1 auf, die von der zentralen Wellenlänge λ2 des von der zweiten Lasereinheit 3 emittierten Laserstrahls 6 verschieden ist. Beide Laserstrahlen 5, 6 der ersten Lasereinheit 2 und der zweiten Lasereinheit 3 sind in einer ersten (gemeinsamen) Richtung polarisiert. Durch die Wellenlängenkopplung wird wiederum der erste resultierende Laserstrahl 9 erhalten. Die dritte Lasereinheit 4 emittiert einen Laserstrahl 7, der in einer zweiten Polarisationsrichtung polarisiert ist, die von der ersten Polarisationsrichtung verschieden ist, insbesondere orthogonal zu dieser orientiert ist. Der Spiegel 10 bildet in dieser Variante im Gegensatz zur ersten Ausführungsvariante kein Wellenlängenkopplungsmittel, sondern ein Polarisationskopplungsmittel. Durch Polarisationskopplung des ersten resultierenden Laserstrahls 9 mit dem von der dritten Lasereinheit 4 emittierten Laserstrahl 7 wird der zweite resultierende Laserstrahl 11 erhalten. Die dielektrische Beschichtung 820 der Lichtaustrittsfläche 82 des Wellenlängenkopplungsprismas weist vorzugsweise für die erste zentrale Wellenlänge λ1 einen Reflexionsgrad R_{λ1} = 0% und einen Transmissionsgrad T_{λ1} = 100% und für die zweite zentrale Wellenlänge λ2 einen Reflexionsgrad P_{λ2} = 100% und einen Transmissionsgrad T_{λ2} = 0% auf. Die dielektrische Beschichtung des Spiegels 10 ist so ausgeführt, dass sie den ersten resultierenden, in der ersten Polarisationsrichtung polarisierten Laserstrahl 9 reflektieren kann und den in der zweiten Polarisationsrichtung polarisierten Laserstrahl 7 der dritten Lasereinheit 4 transmittieren kann, so dass eine Polarisationskopplung erhalten werden kann.

## Patentansprüche

1. Laservorrichtung (1), umfassend
- eine erste Lasereinheit (2), die während des Betriebs einen Laserstrahl (5) emittieren kann, der sich in einer ersten Richtung (x) ausbreitet,
- zumindest eine zweite Lasereinheit (3), die während des Betriebs einen Laserstrahl (6) emittieren kann, der sich in einer zweiten Richtung (z), die von der ersten Richtung (x) verschieden ist und vorzugsweise orthogonal zu der ersten Richtung (x) orientiert ist, ausbreitet, sowie
- ein Polarisationskopplungsmittel, das derart angeordnet und so ausgebildet ist, dass es den Laserstrahl (5) der ersten Lasereinheit (2), der in einer ersten Richtung polarisiert ist, mit dem Laserstrahl (6) der zweiten Lasereinheit (3), der in einer zweiten Richtung polarisiert ist, derart koppeln kann, dass durch eine kollineare Überlagerung der beiden Laserstrahlen (5, 6) ein erster resultierender Laserstrahl (9) erhalten werden kann, **dadurch gekennzeichnet, dass** das Polarisationskopplungsmittel als Polarisationskopplungsprisma (8) ausgebildet ist, das eine Lichteintrittsfläche (80), durch die der Laserstrahl (5) der ersten Lasereinheit (2) in das Polarisationskopplungsprisma (8) eintreten kann, eine Reflexionsfläche (81), die relativ zur Lichteintrittsfläche (80) so angeordnet ist, dass der Laserstrahl (5) der ersten Lasereinheit (2) unter einem Winkel auf die Reflexionsfläche (81) auftrifft, der größer als ein Grenzwinkel der inneren Totalreflexion ist, und eine Lichtaustrittsfläche (82), durch die der Laserstrahl (5) der ersten Lasereinheit (2) nach der inneren Totalreflexion an der Reflexionsfläche (81) aus dem Polarisationskopplungsprisma (8) austreten und an dieser gebrochen werden kann, umfasst und wobei die zweite Lasereinheit (3) relativ zum Polarisationskopplungsprisma (8) so angeordnet ist, dass der Laserstrahl (6) der zweiten Lasereinheit (3) derart auf die Lichtaustrittsfläche (82) auftreffen kann, dass er an dieser in eine Richtung reflektiert werden kann, die der Ausbreitungsrichtung des an der Lichtaustrittsfläche (82) gebrochenen Laserstrahls (5) der ersten Lasereinheit (2) entspricht, so dass durch die kollineare Überlagerung der beiden Laserstrahlen (5, 6) der erste resultierende Laserstrahl (9) erhalten werden kann.

2. Laservorrichtung (1) nach Anspruch 1, **dadurch gekennzeichnet, dass** die Lichteintrittsfläche (80) des Polarisationskopplungsprismas (8) eine Antireflexionsbeschichtung (800) aufweist.

3. Laservorrichtung (1) nach einem der Ansprüche 1 oder 2,
**dadurch gekennzeichnet, dass** die Lichtaustrittsfläche (82) des Polarisationskopplungsprismas (8) eine dielektrische Beschichtung (820) aufweist, die für den in der ersten Richtung polarisierten Laserstrahl (5) der ersten Lasereinheit (2) einen Reflexionsgrad R_{P} = 0% und einen Transmissionsgrad T_{P} = 100% hat.

4. Laservorrichtung (1) nach Anspruch 3, **dadurch gekennzeichnet, dass** die dielektrische Beschichtung (820) für den in der zweiten Richtung polarisierten Laserstrahl (6) der zweiten Lasereinheit (3) einen Reflexionsgrad R_{S} = 100% und einen Transmissionsgrad T_{S} = 0% hat.

5. Laservorrichtung (1) nach einem der Ansprüche 1 bis 4, **dadurch gekennzeichnet, dass** das Polarisationskopplungsprisma (8) relativ zur ersten Lasereinheit (2) derart angeordnet ist, dass der Laserstrahl (5) der ersten Lasereinheit (2) parallel zu einer Oberflächennormalen (N) gerichtet auf die Lichteintrittsfläche (80) auftrifft.

6. Laservorrichtung (1) nach einem der Ansprüche 1 bis 5, **dadurch gekennzeichnet, dass** der Laserstrahl (5) der ersten Lasereinheit (2) in einer Richtung parallel zu einer Einfallsebene, in der dieser Laserstrahl (5) auf das Polarisationskopplungsprisma (8) trifft, polarisiert ist,

7. Laservorrichtung (1) nach einem der Ansprüche 1 bis 6, **dadurch gekennzeichnet, dass** der Laserstrahl (6) der zweiten Lasereinheit (3) in einer Richtung senkrecht zu einer Einfallsebene, in der dieser Laserstrahl (6) auf das Polarisationskopplungsprisma (8) trifft, polarisiert ist.

8. Laservorrichtung (1) nach einem der Ansprüche 1 bis 7, **dadurch gekennzeichnet, dass** der Laserstrahl (5) der ersten Lasereinheit (2) eine zentrale Wellenlänge (λ1) aufweist, die mit einer zentralen Wellenlänge (λ1) des Laserstrahls (6) der zweiten Lasereinheit (3) identisch ist.

9. Laservorrichtung (1) nach einem der Ansprüche 1 bis 8, **dadurch gekennzeichnet, dass** die Laservorrichtung (1) zumindest eine dritte Lasereinheit (4), die während des Betriebs einen Laserstrahl (7) emittieren kann, und ein Wellenlängenkopplungsmittel umfasst, das im Strahlengang der Laservorrichtung (1) derart angeordnet ist, dass es den ersten resultierenden Laserstrahl (9) kollinear mit dem Laserstrahl (7) der dritten Lasereinheit (4) überlagern kann, so dass ein zweiter resultierender Laserstrahl (11) erhalten werden kann, wobei das Wellenlängenkopplungsmittel vorzugsweise als Spiegel (10) ausgebildet ist, der eine mehrlagige dielektrische Beschichtung aufweist.

10. Laservorrichtung (1) nach Anspruch 9, **dadurch gekennzeichnet, dass** das Wellenlängenkopplungsmittel, insbesondere der Spiegel (10), derart im Strahlengang der Laservorrichtung (1) angeordnet ist, dass der erste resultierende Laserstrahl (9) und der Laserstrahl (7) der dritten Lasereinheit (4) beim Auftreffen auf das Wellenlängenkopplungsmittel einen Winkel > 90° miteinander einschließen.

11. Laservorrichtung (1) nach einem der Ansprüche 9 oder 10, **dadurch gekennzeichnet, dass** der Laserstrahl (7) der dritten Lasereinheit (4) eine zentrale Wellenlänge (λ2) aufweist, die von den zentralen Wellenlängen (λ1) der Laserstrahlen (5, 6) der ersten Lasereinheit (2) und der zweiten Lasereinheit (3) verschieden ist.

12. Laservorrichtung (1) nach einem der Ansprüche 9 bis 11, **dadurch gekennzeichnet, dass** die dielektrische Beschichtung des Spiegels (10) so ausgebildet ist, dass sie für den Einfallswinkel, unter dem der von der dritten Lasereinheit (4) emittierte Laserstrahl (7) auf den Spiegel (10) auftrifft, einen Transmissionsgrad T_{λ2} = 100% und einen Reflexionsgrad R_{λ2} = 0% für den Laserstrahl (7) aufweist.

13. Laservorrichtung (1) nach einem der Ansprüche 9 bis 12, **dadurch gekennzeichnet, dass** die dielektrische Beschichtung des Spiegels (10) so ausgebildet ist, dass sie für den Einfallswinkel, unter dem der polarisationsgekoppelte erste resultierende Laserstrahl (9) auf den Spiegel (10) auftrifft, einen Reflexionsgrad R_{λ1} = 100 % und einen Transmissionsgrad T_{λ1} = 0 % aufweist.

14. Laservorrichtung (1), umfassend
- eine erste Lasereinheit (2), die während des Betriebs einen in einer ersten Polarisationsrichtung polarisierten Laserstrahl (5) mit einer zentralen Wellenlänge (λ1) emittieren kann, der sich in einer ersten Richtung (x) ausbreitet,
- zumindest eine zweite Lasereinheit (3), die während des Betriebs einen in der ersten Polarisationsrichtung polarisierten Laserstrahl (6) emittieren kann, der eine zentrale Wellenlänge (λ2) aufweist, die von der zentralen Wellenlänge (λ1) des Laserstrahls (5) der ersten Lasereinheit (2) verschieden ist und der sich in einer zweiten Richtung (z), die von der ersten Richtung (x) verschieden ist und vorzugsweise orthogonal zu der ersten Richtung (x) orientiert ist, ausbreitet, sowie
- ein Wellenlängenkopplungsmittel, das derart angeordnet und so ausgebildet ist, dass es den Laserstrahl (5) der ersten Lasereinheit (2) mit dem Laserstrahl (6) der zweiten Lasereinheit (3), derart koppeln kann, dass durch eine kollineare Überlagerung der beiden Laserstrahlen (5, 6) ein erster resultierender Laserstrahl (9) erhalten werden kann, **dadurch gekennzeichnet, dass** das Wellenlängenkopplungsmittel als Wellenlängenkopplungsprisma (8) ausgebildet ist, das eine Lichteintrittsfläche (80), durch die der Laserstrahl (5) der ersten Lasereinheit (2) in das Wellenlängenkopplungsprisma (8) eintreten kann, eine Reflexionsfläche (81), die relativ zur Lichteintrittsfläche (80) so angeordnet ist, dass der Laserstrahl (5) der ersten Lasereinheit (2) unter einem Winkel auf die Reflexionsfläche (81) auftrifft, der größer als ein Grenzwinkel der inneren Totalreflexion ist, und eine Lichtaustrittsfläche (82), durch die der Laserstrahl (5) der ersten Lasereinheit (2) nach der inneren Totalreflexion an der Reflexionsfläche (81) aus dem Wellenlängenkopplungsprisma (8) austreten und an dieser gebrochen werden kann, umfasst und wobei die zweite Lasereinheit (3) relativ zum Wellenlängenkopplungsprisma (8) so angeordnet ist, dass der Laserstrahl (6) der zweiten Lasereinheit (3) derart auf die Lichtaustrittsfläche (82) auftreffen kann, dass er an dieser in eine Richtung reflektiert werden kann, die der Ausbreitungsrichtung des an der Lichtaustrittsfläche (82) gebrochenen Laserstrahls (5) der ersten Lasereinheit (2) entspricht, so dass durch die kollineare Überlagerung der beiden Laserstrahlen (5, 6) der erste resultierende Laserstrahl (9) erhalten werden kann.

15. Laservorrichtung (1) nach Anspruch 14, **dadurch gekennzeichnet, dass** die Laservorrichtung (1) zumindest eine dritte Lasereinheit (4), die während des Betriebs einen Laserstrahl (7) emittieren kann, der in einer zweiten Polarisationsrichtung polarisiert ist, die von der ersten Polarisationsrichtung verschieden ist, und ein Polarisationskopplungsmittel umfasst, das im Strahlengang der Laservorrichtung (1) derart angeordnet ist, dass es den ersten resultierenden Laserstrahl (9) kollinear mit dem Laserstrahl (7) der dritten Lasereinheit (4) überlagern kann, so dass ein zweiter resultierender Laserstrahl (11) erhalten werden kann, wobei das Polarisationskopplungsmittel vorzugsweise als Spiegel (10) ausgebildet ist, der eine mehrlagige dielektrische Beschichtung aufweist.

## Claims

1. Laser device (1) comprising
- a first laser unit (2) capable of emitting a laser beam (5) during operation, propagating in a first direction (x),
- at least a second laser unit (3) capable of emitting a laser beam (6) during operation, propagating in a second direction (z), which differs from the first direction (x) and is oriented preferably orthogonally to the first direction (x), as well as
- a polarization coupling means, disposed and formed such that it can couple the laser beam (5) of the first laser unit (2), which is polarised in a first direction, with the laser beam (6) of the second laser unit (3), which is polarised in a second direction, such that by a collinear superposition of the two laser beams (5, 6), a first resulting laser beam (9) can be obtained, **characterised in that** the polarisation coupling means is formed as a polarisation coupling prism (8), comprising a light entry surface (80) through which the laser beam (5) of the first laser unit (2) can enter into the polarisation coupling prism (8), a reflection surface (81) disposed relative to the light entry surface (80) in such a manner that the laser beam (5) of the first laser unit (2) impinges on the reflecting surface (81) at an angle greater than a critical angle of total internal reflection, anda light exit surface (82) through which the laser beam (5) of the first laser unit (2) can exit from the polarisation coupling prism (8) after the total internal reflection at the reflection surface (81) and can be refracted thereon, and wherein the second laser unit (3) being disposed relative to the polarisation coupling prism (8) in such a manner that the laser beam (6) of the second laser unit (3) can impinge on the light exit surface (82) such that it can be reflected at this in a direction, which corresponds to the propagation direction of the laser beam (5) of the first laser unit (2) refracted at the light exit surface (82), such that the first resulting laser beam (9) can be obtained by the collinear superposition of the two laser beams (5, 6).

2. Laser device (1) according to claim 1, **characterised in that** the light entry surface (80) of the polarisation coupling prism (8) has an anti-reflection coating (800).

3. Laser device (1) according to one of claims 1 or 2, **characterised in that** the light exit surface (82) of the polarisation coupling prism (8) has a dielectric coating (820) that has a reflectance Rp = 0% and a transmittance Tp = 100% for the laser beam (5) of the first laser unit (2) polarised in the first direction.

4. Laser device (1) according to claim 3, **characterised in that** the dielectric coating (820) has a reflectance Rs = 100% and a transmittance Ts = 0% for the laser beam (6) of the second laser unit (3) polarised in the second direction.

5. Laser device (1) according to one of claims 1 to 4, **characterised in that** the polarisation coupling prism (8) is disposed relative to the first laser unit (2) in such a manner that the laser beam (5) of the first laser unit (2) impinges on the light entry surface (80) parallel to a surface normal (N).

6. Laser device (1) according to one of claims 1 to 5, **characterised in that** the laser beam (5) of the first laser unit (2) is polarised in a direction parallel to an incident plane in which this laser beam (5) impinges on the polarisation-coupling prism (8).

7. Laser device (1) according to one of claims 1 to 6, **characterised in that** the laser beam (6) of the second laser unit (3) is polarised in a direction perpendicular to an incident plane in which this laser beam (6) impinges on the polarisation coupling prism (8).

8. Laser device (1) according to one of claims 1 to 7, **characterised in that** the laser beam (5) of the first laser unit (2) has a central wavelength (λ1) that is identical to a central wavelength (λl) of the laser beam (6) of the second laser unit (3).

9. Laser device (1) according to one of claims 1 to 8, **characterised in that** the laser device (1) comprises at least a third laser unit (4) capable of emitting a laser beam (7) during operation, and comprises a wavelength coupling means that is disposed in the beam path of laser device (1) in such a manner that it can superimpose the first resulting laser beam (9) collinearly with the laser beam (7) of the third laser unit (4), such that a second resulting laser beam (11) can be obtained, wherein the wavelength coupling means is preferably formed as a mirror (10) which has a multilayer dielectric coating.

10. Laser device (1) according to claim 9, **characterised in that** the wavelength coupling means, in particular the mirror (10), is disposed in the beam path of the laser device (1) in such a manner that the first resulting laser beam (9) and the laser beam (7) of the third laser unit (4) enclose an angle > 90° with each other upon impinging on the wavelength coupling means.

11. Laser device (1) according to one of claims 9 or 10, **characterised in that** the laser beam (7) of the third laser unit (4) has a central wavelength (λ2) that differs from the central wavelengths (λ1) of the laser beams (5, 6) of the first laser unit (2) and the second laser unit (3).

12. Laser device (1) according to one of claims 9 to 11, **characterised in that** the dielectric coating of the mirror (10) is formed in such a manner that, for the angle of incidence, under which the laser beam (7) emitted from the third laser unit (4) impinges on the mirror (10), it has a transmittance T_{λ2} = 100% and a reflectance R_{λ2} = 0% for the laser beam (7).

13. Laser device (1) according to one of claims 9 to 12, **characterised in that** the dielectric coating of the mirror (10) is formed in such a manner that, for the angle of incidence at which the polarisation-coupled first resulting laser beam (9) impinges on the mirror (10), it has a reflectance R_{λ1} = 100 % and a transmittance T_{λ1} = 0 %.

14. Laser device (1) comprising
- a first laser unit (2) that, during operation, is capable of emitting a laser beam (5) polarised in a first polarisation direction with a central wavelength (λ1), propagating in a first direction (x),
- at least a second laser unit (3) that, during operation, is capable of emitting a laser beam (6) polarised in the first polarisation direction with a central wavelength (λ2) that differs from the central wavelength (λ1) of the laser beam (5) of the first laser unit (2) and propagating in a second direction (z), which is different from the first direction (x) and is preferably oriented orthogonally to the first direction (x), and
- a wavelength coupling means, disposed and formed in such a manner that it can couple the laser beam (5) of the first laser unit (2) with the laser beam (6) of the second laser unit (3), such that by a collinear superposition of the two laser beams (5, 6) a first resulting laser beam (9) can be obtained, **characterised in that** the wavelength coupling means is formed as a wavelength coupling prism (8), comprising a light entry surface (80) through which the laser beam (5) of the first laser unit (2) can enter into the wavelength coupling prism (8), a reflection surface (81) disposed relative to the light entry surface (80) in such a manner that the laser beam (5) of the first laser unit (2) impinges on the reflecting surface (81) at an angle greater than a critical angle of total internal reflection, and a light exit surface (82) through which the laser beam (5) of the first laser unit (2) can exit from the wavelength coupling prism (8) after the total internal reflection at the reflection surface (81) and be refracted thereon, and wherein the second laser unit (3) being disposed relative to the wavelength coupling prism (8) in such a manner that the laser beam (6) of the second laser unit (3) can impinge on the light exit surface (82) such that it can be reflected at this in a direction, which corresponds to the propagation direction of the laser beam (5) of the first laser unit (2) refracted at the light exit surface (82), such that the first resulting laser beam (9) can be obtained by the collinear superposition of the two laser beams (5, 6).

15. Laser device (1) according claim 14, **characterised in that** the laser device (1) comprises at least a third laser unit (4) capable of emitting a laser beam (7) during operation, which is polarised in a second polarisation direction that differs from the first polarisation direction, and comprises a polarisation coupling means that is disposed in the beam path of the laser device (1) in such a manner that it can superimpose the first resulting laser beam (9) collinearly with the laser beam (7) of the third laser unit (4), such that a second resulting laser beam (11) can be obtained, wherein the polarisation coupling means is preferably formed as a mirror (10) which has a multilayer dielectric coating.

## Revendications

1. Dispositif laser (1), comprenant
- une première unité laser (2), qui peut émettre pendant le fonctionnement un rayon laser (5) qui se propage dans une première direction (x),
- au moins une deuxième unité laser (3), qui peut émettre pendant le fonctionnement un rayon laser (6) qui se propage dans une deuxième direction (z), qui est différente de la première direction (x) et qui est orientée de préférence perpendiculairement à la première direction (x), ainsi que
- un moyen de couplage de polarisation, qui est agencé et réalisé de telle sorte qu'il peut coupler le rayon laser (5) de la première unité laser (2), qui est polarisé dans une première direction, avec le rayon laser (6) de la deuxième unité laser (3), qui est polarisé dans une deuxième direction, de telle sorte qu'un premier rayon laser résultant (9) peut être obtenu par superposition colinéaire des deux rayons laser (5, 6),
**caractérisé en ce que** le moyen de couplage de polarisation est réalisé comme un prisme de couplage de polarisation (8) qui comprend une surface d'entrée de lumière (80), par laquelle le rayon laser (5) de la première unité laser (2) peut entrer dans le prisme de couplage de polarisation (8), une surface de réflexion (81), qui est agencée de telle sorte par rapport à la surface d'entrée de lumière (80) que le rayon laser (5) de la première unité laser (2) arrive sur la surface de réflexion (81) avec un angle qui est supérieur à un angle limite de la réflexion interne totale, et une surface de sortie de lumière (82), par laquelle le rayon laser (5) de la première unité laser (2) peut sortir du prisme de couplage de polarisation (8) après la réflexion interne totale au niveau de la surface de réflexion (81) et peut être réfracté au niveau de celle-ci, et **en ce que** la deuxième unité laser (3) est agencée de telle sorte par rapport au prisme de couplage de polarisation (8) que le rayon laser (6) de la deuxième unité laser (3) peut arriver de telle sorte sur la surface de sortie de lumière (82) qu'il peut être réfléchi au niveau de celle-ci dans une direction qui correspond à la direction de propagation du rayon laser (5) de la première unité laser (2) réfracté au niveau de la surface de sortie de lumière (82) de telle sorte que le premier rayon laser résultant (9) peut être obtenu par superposition colinéaire des deux rayons lasers (5, 6).

2. Dispositif laser (1) selon la revendication 1, **caractérisé en ce que** la surface d'entrée de lumière (80) du prisme de couplage de polarisation (8) a un revêtement antiréfléchissant (800).

3. Dispositif laser (1) selon l'une quelconque des revendications 1 ou 2, **caractérisé en ce que** la surface de sortie de lumière (82) du prisme de couplage de polarisation (8) a un revêtement diélectrique (820) qui a, pour le rayon laser (5) de la première unité laser (2) polarisé dans la première direction, un taux de réflexion R_{P} = 0 % et un taux de transmission T_{P} = 100 %.

4. Dispositif laser (1) selon la revendication 3, **caractérisé en ce que** le revêtement diélectrique (820) a, pour le rayon laser (6) de la deuxième unité laser (3) polarisé dans la deuxième direction, un taux de réflexion R_{S} = 100 % et un taux de transmission T_{S} = 0 %.

5. Dispositif laser (1) selon l'une quelconque des revendications 1 à 4, **caractérisé en ce que** le prisme de couplage de polarisation (8) est agencé de telle sorte par rapport à la première unité laser (2) que le rayon laser (5) de la première unité laser (2) arrive sur la surface d'entrée de lumière (80) de manière orientée parallèlement à une normale (N) à ladite surface.

6. Dispositif laser (1) selon l'une quelconque des revendications 1 à 5, **caractérisé en ce que** le rayon laser (5) de la première unité laser (2) est polarisé dans une direction parallèle à un plan d'incidence, dans lequel ce rayon laser (5) arrive sur le prisme de couplage de polarisation (8).

7. Dispositif laser (1) selon l'une quelconque des revendications 1 à 6, **caractérisé en ce que** le rayon laser (6) de la deuxième unité laser (3) est polarisé dans une direction perpendiculaire à un plan d'incidence, dans lequel ce rayon laser (6) arrive sur le prisme de couplage de polarisation (8).

8. Dispositif laser (1) selon l'une quelconque des revendications 1 à 7, **caractérisé en ce que** le rayon laser (5) de la première unité laser (2) a une longueur d'onde centrale (λ1) qui est identique à la longueur d'onde centrale (λ1) du rayon laser (6) de la deuxième unité laser (3).

9. Dispositif laser (1) selon l'une quelconque des revendications 1 à 8, **caractérisé en ce que** le dispositif laser (1) comprend au moins une troisième unité laser (4), qui peut émettre pendant le fonctionnement un rayon laser (7), et un moyen de couplage de longueur d'onde, qui est agencé de telle sorte dans le trajet de rayon du dispositif laser (1) qu'il peut superposer le premier rayon laser résultant (9) de manière colinéaire avec le rayon laser (7) de la troisième unité laser (4) de telle sorte qu'un deuxième rayon laser résultant (11) peut être obtenu, lequel moyen de couplage de longueur d'onde est réalisé de préférence comme un miroir (10) qui a un revêtement diélectrique multicouche.

10. Dispositif laser (1) selon la revendication 9, **caractérisé en ce que** le moyen de couplage de longueur d'onde, en particulier le miroir (10), est agencé de telle sorte dans le trajet de rayon du dispositif laser (1) que le premier rayon laser résultant (9) et le rayon laser (7) de la troisième unité laser (4) forment un angle > 90° lors de l'arrivée sur le moyen de couplage de longueur d'onde.

11. Dispositif laser (1) selon l'une quelconque des revendications 9 ou 10, **caractérisé en ce que** le rayon laser (7) de la troisième unité laser (4) a une longueur d'onde centrale (λ2) qui est différente de la longueur d'onde centrale (λ1) des rayons laser (5, 6) de la première unité laser (2) et de la deuxième unité laser (3).

12. Dispositif laser (1) selon l'une quelconque des revendications 9 à 11, **caractérisé en ce que** le revêtement diélectrique du miroir (10) est réalisé de telle sorte qu'il a, pour l'angle d'incidence avec lequel le rayon laser (7) émis par la troisième unité laser (4) arrive sur le miroir (10), un taux de transmission T_{λ2} = 100% et un taux de réflexion R_{λ2} = 0 % pour le rayon laser (7).

13. Dispositif laser (1) selon l'une quelconque des revendications 9 à 12, **caractérisé en ce que** le revêtement diélectrique du miroir (10) est réalisé de telle sorte qu'il a, pour l'angle d'incidence avec lequel le premier rayon laser résultant (9) couplé en polarisation arrive sur le miroir (10), un taux de réflexion R_{λ1} = 100 % et un taux de transmission T_{λ1} = 0 %.

14. Dispositif laser (1), comprenant
- une première unité laser (2), qui peut émettre pendant le fonctionnement un rayon laser (5) qui est polarisé dans une première direction de polarisation, qui a une longueur d'onde centrale (λ1) et qui se propage dans une première direction (x),
- au moins une deuxième unité laser (3), qui peut émettre pendant le fonctionnement un rayon laser (6) qui est polarisé dans la première direction de polarisation, qui a une longueur d'onde centrale (λ2), qui est différente de la longueur d'onde centrale (λ1) du rayon laser (5) de la première unité laser (2), et qui se propage dans une deuxième direction (z), qui est différente de la première direction (x) et qui est orientée de préférence perpendiculairement à la première direction (x), ainsi que
- un moyen de couplage de longueur d'onde, qui est agencé et réalisé de telle sorte qu'il peut coupler le rayon laser (5) de la première unité laser (2) avec le rayon laser (6) de la deuxième unité laser (3) de telle sorte qu'un premier rayon laser résultant (9) peut être obtenu par superposition colinéaire des deux rayons laser (5, 6),
**caractérisé en ce que** le moyen de couplage de longueur d'onde est réalisé comme un prisme de couplage de longueur d'onde (8) qui comprend une surface d'entrée de lumière (80), par laquelle le rayon laser (5) de la première unité laser (2) peut entrer dans le prisme de couplage de longueur d'onde (8), une surface de réflexion (81), qui est agencée de telle sorte par rapport à la surface d'entrée de lumière (80) que le rayon laser (5) de la première unité laser (2) arrive sur la surface de réflexion (81) avec un angle qui est supérieur à un angle limite de la réflexion interne totale, et une surface de sortie de lumière (82), par laquelle le rayon laser (5) de la première unité laser (2) peut sortir du prisme de couplage de longueur d'onde (8) après la réflexion interne totale au niveau de la surface de réflexion (81) et peut être réfracté au niveau de celle-ci, et **en ce que** la deuxième unité laser (3) est agencée de telle sorte par rapport au prisme de couplage de longueur d'onde (8) que le rayon laser (6) de la deuxième unité laser (3) peut arriver de telle sorte sur la surface de sortie de lumière (82) qu'il peut être réfléchi au niveau de celle-ci dans une direction qui correspond à la direction de propagation du rayon laser (5) de la première unité laser (2) réfracté au niveau de la surface de sortie de lumière (82) de telle sorte que le premier rayon laser résultant (9) peut être obtenu par superposition colinéaire des deux rayons lasers (5, 6).

15. Dispositif laser (1) selon la revendication 14, **caractérisé en ce que** le dispositif laser (1) comprend au moins une troisième unité laser (4), qui peut émettre pendant le fonctionnement un rayon laser (7) qui est polarisé dans une deuxième direction de polarisation qui est différente de la première direction de polarisation, et un moyen de couplage de polarisation, qui est agencé de telle sorte dans le trajet de rayon du dispositif laser (1) qu'il peut superposer le premier rayon laser résultant (9) de manière colinéaire avec le rayon laser (7) de la troisième unité laser (4) de telle sorte qu'un deuxième rayon laser résultant (11) peut être obtenu, lequel moyen de couplage de polarisation est réalisé de préférence comme un miroir (10) qui a un revêtement diélectrique multicouche.
